Europäisches Patentamt

European Patent Office

Office européen des brevets

(19)

(11) **EP 0 430 104 B1**

(12) **EUROPEAN PATENT SPECIFICATION**

(45) Date of publication and mention
of the grant of the patent:
**15.04.1998 Bulletin 1998/16**

(51) Int Cl.6: **G01R 33/36**, G01R 33/38,
G01R 33/42

(21) Application number: **90122419.6**

(22) Date of filing: **23.11.1990**

(54) **Magnetic resonance imaging apparatus**

Apparat zur Bilderzeugung mittels magnetischer Resonanz

Appareil d'imagerie par résonance magnétique

(84) Designated Contracting States:
**DE GB**

(30) Priority: **28.11.1989 JP 308547/89**

(43) Date of publication of application:
**05.06.1991 Bulletin 1991/23**

(73) Proprietor: **KABUSHIKI KAISHA TOSHIBA**
**Kawasaki-shi, Kanagawa-ken 210 (JP)**

(72) Inventor: **Konishi, Mineyuki,**
**c/o Intellectual Property Div.**
**Minato-ku, Tokyo 105 (JP)**

(74) Representative:
**Blumbach, Kramer & Partner GbR**
**Radeckestrasse 43**
**81245 München (DE)**

(56) References cited:
**EP-A- 0 151 726        DE-A- 3 445 724**
**DE-A- 3 445 724        DE-A- 3 621 107**
**US-A- 4 879 515        US-A- 4 924 184**

• **PATENT ABSTRACTS OF JAPAN, vol. 13, no.**
**115 (C-578)[3463], 20th March 1989; & JP-A-63**
**290 554 (YOKOGAWA MEDICAL SYSTEMS LTD)**
**28-11-1988**

# Description

The present invention relates to a magnetic resonance imaging apparatus employing nuclear magnetic resonance (NMR) phenomena and, more particularly, to a magnetic resonance imaging apparatus with an improved radio-frequency shielding body.

The nuclear magnetic resonance is a phenomenon in which atomic nuclei placed in magnetic fields absorb electromagnetic energy at specific frequencies and then emit the energy as electromagnetic waves. A diagnostic apparatus employing the phenomenon senses electromagnetic waves emitted by the atomic nuclei, protons in particular, and processes received signals to obtain diagnostic information of a subject under examination, such as a tomographic image, which contains the atomic nucleus density (the proton density in particular), the longitudinal spin-lattice relaxation time T1, the transversal spin-lattice relaxation time T2, flow, chemical shifts and so on.

The magnetic resonance imaging apparatus for obtaining cross-sectional NMR images of a subject under examination is provided with gradient magnetic field forming coils for forming gradient magnetic fields which serve to obtain position information of a body portion in which magnetic resonance signals are induced and a radio-frequency coil responsive to application of a radio-frequency pulse thereto for radiating a radio-frequency magnetic field serving to induce the magnetic resonance signals in the body portion and detecting the induced magnetic resonance signals. Between the gradient magnetic field forming coils and the radio-frequency coil is disposed a radio-frequency shielding body for interrupting electromagnetic coupling between the gradient magnetic field forming coils and the radio-frequency coil due to the radio-frequency pulse applied to the radio-frequency coil.

The radio-frequency shielding body is generally formed of metallic foil made of a good conductor such as copper. However, eddy currents will be induced in the surface of the radio-frequency shielding body by time-varying gradient magnetic fields formed by the gradient magnetic field forming coils. A problem arises due to the eddy currents in that the rising and falling characteristics of the gradient magnetic fields are deteriorated. As a result, resulting cross-sectional NMR images will have poor quality.

In order to solve the problem with the radio-frequency shielding body, an approach has been proposed in Japanese Unexamined Patent Publication No. 60-177249 according to which a metallic foil consisting of first and second conductive regions separated by a relatively narrow nonconductive region, such as a slit, is used to form the radio-frequency shielding body.

Other techniques have been proposed in Japanese Unexamined Patent Publication No. 62-334. That is to say, a metal cylinder, which forms a radio-frequency shielding body, is provided with a lengthwise slit so as to decrease eddy currents by confining them locally, or a metal cylinder is formed of plural pieces of metallic foil connected by insulating materials or dielectric materials so as to reduce impedance of a radio-frequency shielding body to a radio-frequency pulse and to thereby reduce undesirable electromagnetic coupling between the gradient magnetic field coils and the radio-frequency coil.

However, such a radio-frequency shielding body is complex in structure and costly because of the provision of the metallic foil with a slit or interposition of a insulating material or dielectric material between pieces of metallic foil.

According to still another proposal in Japanese Unexamined Patent Publication No. 63-290554, the radio-frequency shielding body is formed of a metal cylinder made of copper foil having a thickness not less than the skin depth. The skin depth is the depth in the direction to the center of the cylinder at which the amplitude of electromagnetic waves decays to $1/e$ ($e = 2.718..$, the base of the natural logarithm). More specifically, when electromagnetic waves with the Larmor frequency of protons penetrate into a cylinder made of some metal by a depth of $\delta$ in the direction to the center of the cylinder, if the amplitude of all the electromagnetic waves decays to $1/e$ at the depth $\delta$, then the skin depth is defined as $\delta$.

In the case of a radio-frequency shielding body with a thickness less than the skin depth, the time constant of eddy currents can be made small so that the time it takes for eddy currents to dissipate is effectively shortened. However, the technique disclosed in the Publication, which is directed to a radio-frequency shielding body made of a metal cylinder, implies that it is impossible to make a radio-frequency shielding body having a thickness less than the skin depth.

As described above, the conventional radio-frequency shielding bodies are complex in structure and costly.

EP-A-0 151 726 discloses a magnetic resonance image apparatus wherein the radio-frequency shielding body between the gradient coil and the radio-frequency coil is formed of a relatively thick material wherein the thickness of the dielectric material alone (without the additional thickness of the covering, electrically conductive material) is already approximately 100 to 200 $\mu$m. Hence, the total thickness of the shielding body made up of such a structure, has a total thickness of several skin depths. The electrically conductive layers covering the dielectric base material are patterned so as to improve the coil performance.

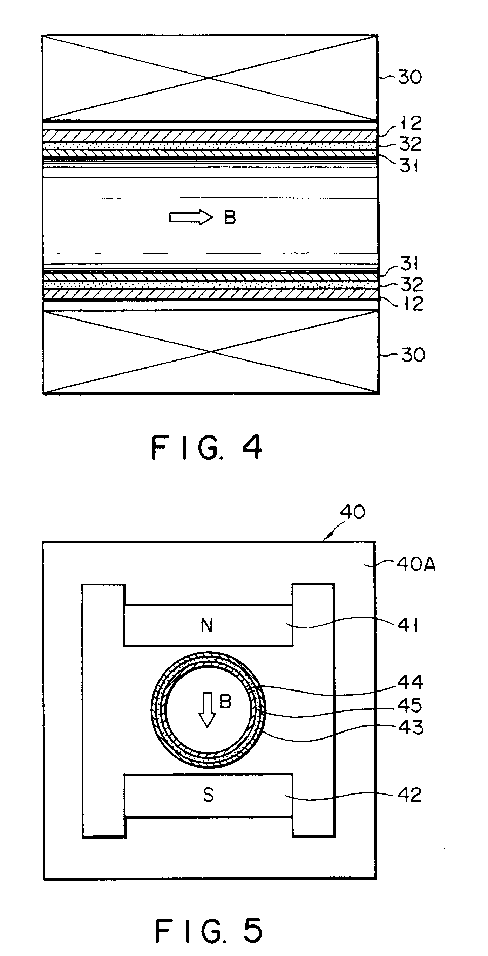

JP-A-1-259848 discloses a magnetic resonance imaging apparatus comprising a radio-frequency shielding body being arranged between the radio-frequency coil means and the gradient magnetic field generating coil. The radio-frequency shield member comprises a plurality of electrically conductive strips being arranged in an at least partly overlapping relationship, and a plurality of non-conductor strips sandwiched between each two adjacent conductive strips. The conductor strips and the non-conductor strips may have a thickness from 10 μm to 100 μm. Due to the stacking and overlapping arrangement, the total thickness of the shielding body is significantly greater than this strip thickness (compare Fig. 4).

It is therefore an object of the present invention to provide a magnetic resonance imaging apparatus which is provided with a radio-frequency shielding body which is simple in construction and sufficiently interrupts electromagnetic coupling between gradient magnetic field forming coils and a radio-frequency coil due to a radio-frequency pulse applied to the radio-frequency coil so as not to deteriorate the rising and falling characteristics of gradient magnetic fields.

The object of the present invention is attained by a magnetic resonance imaging apparatus in accordance with claim 1.

With the magnetic resonance imaging apparatus of the present invention, since the radio-frequency shielding body is formed of a conductive material having a thickness less than $1/\sqrt{\pi \text{ fo } \mu \text{ } \sigma}$, the time constant of eddy currents induced in the surface of the radio-frequency shielding body in accordance with variations in the gradient magnetic fields with time can be made small and thus the eddy currents decay quickly. As a result, the rising and falling characteristics of the gradient magnetic fields will become abrupt, whereby good tomographic images are obtained. More specifically, the time constant of the eddy currents induced in the radio-frequency shielding body is in inverse proportion to the resistance of the radio-frequency shielding body, while the resistance is in proportion to the thickness of the radio-frequency shielding body. Therefore, the time constant of the eddy currents can be made small by decreasing the thickness of the radiofrequency shielding body.

The radio-frequency shielding body may have a shape similar to that of the gradient magnetic field generating coil means.

This invention can be more fully understood from the following detailed description when taken in conjunction with the accompanying drawings, in which:

Fig. 1 is a diagrammatic representation of a magnetic resonance imaging apparatus of the present invention;
Fig. 2 is a cross-sectional view illustrating a radio-frequency shielding coil of the present invention;
Fig. 3 is a sectional view taken along the line III-III of Fig. 2;
Fig. 4 is a sectional view of a radio-frequency shielding body according to another embodiment of the present invention; and
Fig. 5 is a sectional view of a radio-frequency shielding body according to still another embodiment of the present invention.

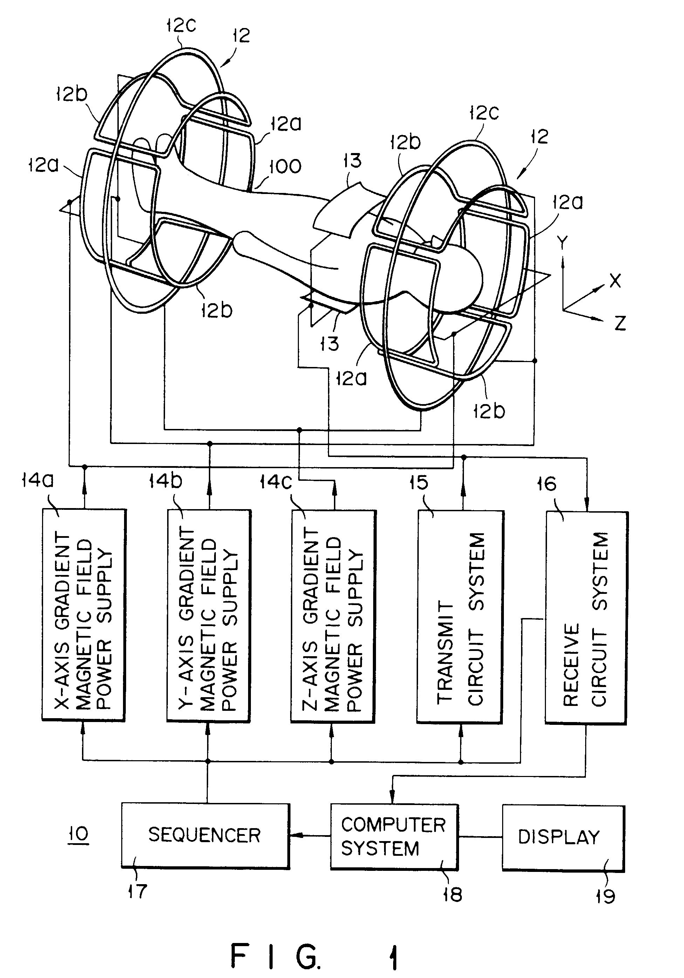

Hereinafter the embodiments of the present invention will be described with reference to the drawings. Fig. 1 is a grammatical representation of a nuclear magnetic resonance imaging apparatus embodying the present invention.

As illustrated in Fig. 1, the magnetic resonance imaging apparatus, which is generally indicated at 10, includes gradient magnetic field forming coils 12 for forming gradient magnetic fields adapted to acquire information on the position of a body portion of a subject under examination 100 in which magnetic resonance signals are induced and a radio-frequency coil 13 responsive to application of a radio-frequency pulse thereto for radiating to the subject a radio-frequency magnetic field adapted to induce the magnetic resonance signals and for detecting the induced magnetic resonance signals. More specifically, with the lengthwise axis of the subject under examination 100 taken as the Z axis and the axes orthogonal to the Z axis taken as the X and Y axes, the gradient magnetic field forming coils 12 comprise a X-axis gradient magnetic field forming coil 12a for forming a gradient magnetic field in the X-axis direction, a Y-axis gradient magnetic field forming coil 12b for forming a gradient magnetic field in the Y-axis direction and a Z-axis gradient magnetic field forming coil 12c for forming a gradient magnetic field in the Z-axis direction. The gradient magnetic field forming coils 12a, 12b and 12c are connected to an X-axis gradient magnetic field power supply 14a, a Y-axis gradient magnetic field power supply 14b and a Z-axis gradient magnetic field power supply 14c, respectively. The radio-frequency coil 13 is connected to a transmit circuit system 15 and a receive circuit system 16.

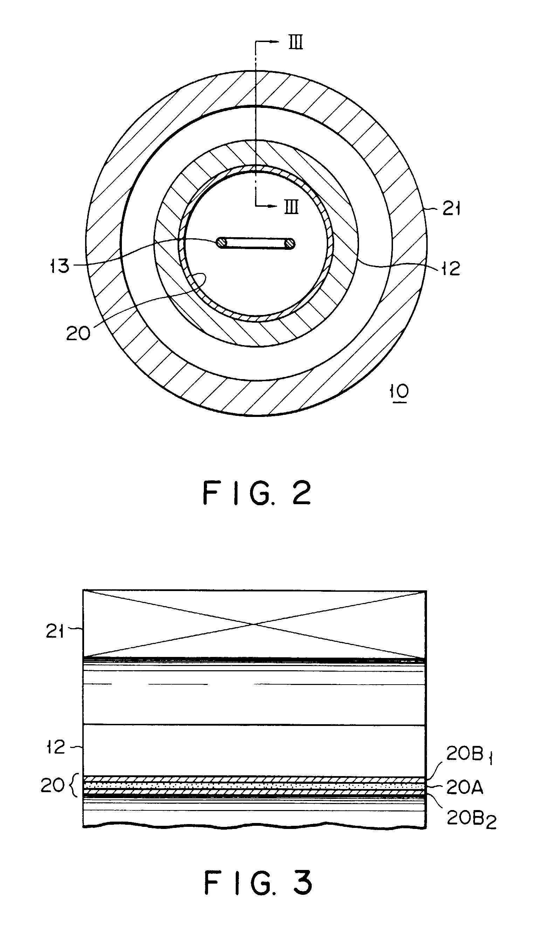

The apparatus 10 is further provided with a sequencer 17 for practicing an imaging pulse sequence and a computer system 18 for controlling all of the power supplies 14a, 14b and 14c, the transmit circuit system 15, the receive circuit system 16 and the sequencer and processing the detected NMR signals. Signals processed by the computer system 18 are displayed on a display 19. The apparatus is provided with a static magnetic field forming coil (refer to Fig. 2) for applying a static magnetic field to the subject 100 in the Z-axis direction and a power supply (not shown) for supplying the static magnetic field forming coil with current as well.

As illustrated in Fig. 2, on the inside of the gradient magnetic field forming coils 12 of the apparatus 10 is mounted a cylindrical radio-frequency shielding body 20 adapted for interrupting electromagnetic coupling between the gradient magnetic field forming coils 12 and the radio-frequency coil 13 due to a radio-frequency pulse applied to the radio-frequency coil 13. In Fig. 2, like reference numerals are used to designate corresponding parts to those in Fig. 1. Reference numeral 21 designates the static magnetic field coil adapted to form a static magnetic field along the Z-axis direction of the subject 100 of Fig. 1.

The radio-frequency shielding body 20 for use in the apparatus consists of copper-plated metal which is about 10 μm in thickness and formed on the surface of a base consisting of an organic fiber textile made of, for example, polyester cloth. Since the radio-frequency shielding body 20 is thinner than the skin depth of 30 μ which is represented by $1/\sqrt{\pi\ fo\ \mu\ \sigma}$ (where fo = 63.874 MHz, the Larmor frequency of protons), the rising and falling characteristics of the gradient magnetic field forming coils 12 will not be deteriorated.

As illustrated in Fig. 3, the radio-frequency shielding body 20 consists of copper layers 20B1 and 20B2 plated on both sides of a base 20. This structure permits the radio-frequency shielding body 20 of a thickness less than the skin depth to be obtained.

Besides the above embodiment, the radio-frequency shielding body may be formed of a conductive layer formed on the surface of a sheet of insulating material. Also, an evaporated film may be used as the radio-frequency shielding body. In addition, it is desirable that the radio-frequency shielding body 20 have a thickness from 5 to 10 μ which can be manufactured.

Next, another embodiment of the magnetic resonance imaging apparatus of the present invention will be described with reference to Fig. 4. The apparatus shown in Fig. 4 includes a transversal magnetic field forming electromagnet 30 for use as the static magnetic field forming device. As the transversal magnetic field forming electromagnet 30 a desired one may be selected from among various types of electromagnets such as a solenoid coil type magnet, a solenoid coil type superconducting magnet, a Helmholtz type electromagnet, etc. The electromagnet 30 has cylindrical space therein. A static magnetic field Bo is produced in the cylindrical space. A cylindrical gradient magnetic field forming coil 12 is disposed in the cylindrical space. A whole-body transmit and receive radio-frequency coil 31 is disposed inside the cylindrical gradient magnetic field coil 12. Furthermore, a radio-frequency shielding body 32 formed in the shape of a cylinder is disposed between the cylindrical gradient magnetic field coil 12 and the whole-body transmit and receive radio-frequency coil 31. This radio-frequency shielding body 32 is substantially the same as that illustrated in Fig. 2.

Next, still another embodiment of the magnetic resonance imaging apparatus of the present invention will be described with reference to Fig. 5. The apparatus shown in Fig. 5 includes a longitudinal magnetic field forming magnet 40 as the static magnetic field forming device. As the magnet 40 a desired one may be selected from among various types of magnets such as a permanent magnet, an ordinary electromagnet, a superconducting magnet, etc. The magnet 40 has first and second magnetic poles 41 and 42 which face each other and are attached to a yoke 40A. A static magnetic field Bo is formed in the space between the first and second magnetic poles 41 and 42. A gradient magnetic field coil 43 is disposed in the space between the first and second magnetic poles. A whole-body transmit and receive radio-frequency coil 44 is disposed inside the gradient magnetic field coil 43. Furthermore, a radio-frequency shielding body 45 formed in the shape of a cylinder is disposed between the gradient magnetic field coil 43 and the whole-body transmit and receive radio-frequency coil 44. This radio-frequency shielding body 45 is substantially the same as that illustrated in Fig. 2.

As can be seen from the foregoing, according to the present invention, a magnetic resonance imaging apparatus can be provided which is provided with a radio-frequency shielding body that is simple in construction and permits electromagnetic coupling between a gradient magnetic field coil and a radio-frequency coil due to a radio-frequency pulse applied to the radio-frequency coil to be interrupted sufficiently so as not to deteriorate the rising and falling characteristics of gradient magnetic fields.

## Claims

1. A magnetic resonance imaging apparatus comprising:

   static magnetic field generating means (21) arranged to generate a static magnetic field along the direction of a first axis;
   gradient magnetic field generating coil means (12; 12a, 12b, 12c) for generating gradient magnetic fields along the direction of said first axis and the direction of second and third axes orthogonal to said first axis;
   a radio-frequency coil means (13) for transmitting or receiving electromagnetic waves from a direction other than the direction of said first axis; and
   a radio-frequency shielding body (20, 32, 45) disposed between said gradient magnetic field generating coil means (12; 12a, 12b, 12c) and said radio-frequency coil means (13) and having a thickness along the directions of said second and third axes; said radio-frequency shielding body (20, 32, 45) being arranged to interrupt electromagnetic coupling between said gradient magnetic field generating coil means (12; 12a, 12b, 12c) and said radio-frequency coil means (13) resulting from a radio-frequency pulse applied to said radio-frequency coil means (13) and reduce a time constant of eddy currents generated in the surface of said gradient magnetic field generating coil means (12; 12a, 12b, 12c),

   characterized in that said radio-frequency shielding body (20, 32, 45) has been formed by evaporating or plating a continuous layer (20B) of a conductive material on an insulating base (20A), the conductive material having a thickness less than

$1/\sqrt{\pi\ \text{fo}\ \mu\ \sigma}$ where: $\pi$ is a constant equal to the ratio of the circumference of a circle to its diameter, fo is the Larmor frequency of protons in said static magnetic field, $\sigma$ is the conductivity of said conductive material and $\mu$ is the magnetic permeability of said conductive material.

2. A magnetic resonance imaging apparatus according to claim 1, characterized in that said radio-frequency shielding body (20) is disposed close to the radio-frequency coil side of said gradient magnetic field generating coil means (12; 12a, 12b, 12c).

3. A magnetic resonance imaging apparatus according to claim 1 or 2, characterized in that said radio-frequency shielding body (20, 32, 45) has a shape similar to that of said gradient magnetic field generating coil means (12; 12a, 12b, 12c).

4. A magnetic resonance imaging apparatus according to claim 1, 2 or 3, characterized in that said gradient magnetic field generating coil means (12; 12a, 12b, 12c) has a cylindrical shape, and said radio-frequency shielding body (20) has a cylindrical shape.

5. A magnetic resonance imaging apparatus according to any of claims 1 to 4, characterized in that said insulating base is an organic fiber.

6. A magnetic resonance imaging apparatus according to claim 5, characterized in that said organic fiber is made of polyester.

7. A magnetic resonance imaging apparatus according to any of claims 1 to 6, characterized in that said thickness of said radio-frequency shielding body (20) is about 10 μm.

8. A magnetic resonance imaging apparatus according to any of the preceding claims, characterized in that said conductive material is copper.

9. A magnetic resonance imaging apparatus according to any of the preceding claims, characterized in that said radio-frequency coil means (13) is a whole-body transmit and receive coil which is disposed coaxially with said gradient magnetic field generating coil means (12; 12a, 12b, 12c).

10. A magnetic resonance imaging apparatus according to any of claims 1 to 8, characterized in that said radio-frequency coil means (13) comprises a transmit and/or receive coil which is disposed inside said gradient magnetic field generating coil means (12; 12a, 12b, 12c) with a space between them.

11. A magnetic resonance imaging apparatus according to any of claims 1 to 8, characterized in that said radio-frequency coil means (13) is a whole-body transmit and receive coil which is disposed coaxially with said gradient magnetic field generating coil means (12; 12a, 12b, 12c) and a transmit and/or receive coil which is disposed inside said gradient magnetic field generating coil means (12; 12a, 12b, 12c) with a space between them.

12. A magnetic resonance imaging apparatus according to any of claims 1 to 11, characterized in that said static magnetic field generating means (21) comprises an electromagnet for generating a static magnetic field horizontally.

13. A magnetic resonance imaging apparatus according to any of claims 1 to 11, characterized in that said static magnetic field generating means (21) comprises an electromagnet for generating a static magnetic field vertically.

14. A magnetic resonance imaging apparatus according to any of claims 1 to 11, characterized in that said static magnetic field generating means (21) comprises a permanent magnet for generating a static magnetic field horizontally.

15. A magnetic resonance imaging apparatus according to any of claims 1 to 11, characterized in that said static magnetic field generating means (21) comprises a permanent magnet for generating a static magnetic field vertically.

**Patentansprüche**

1. Mit Magnetresonanz arbeitendes Bildgabegerät, mit:

   einer Statikmagnetfelderzeugungseinrichtung (21), die zum Erzeugen eines statischen Magnetfelds entlang der Richtung einer ersten Achse ausgelegt ist,
   einer Gradientenmagnetfelderzeugungs-Spuleneinrichtung (12; 12a, 12b, 12c) zum Erzeugen von Gradientenmagnetfeldern entlang der Richtung der ersten Achse und der Richtung von zweiten und dritten Achsen, die rechtwinklig zu der ersten Achse verlaufen,
   einer Hochfrequenzspuleneinrichtung (13) zum Senden oder Empfangen von elektromagnetischen Wellen aus einer Richtung, die sich von der Richtung der ersten Achse unterscheidet, und
   einem Hochfrequenzabschirmkörper (20, 32, 45), der zwischen der Gradientenmagnetfelderzeugungs-Spuleneinrichtung (12; 12a, 12b, 12c) und der Hochfrequenzspuleneinrichtung (13) angeordnet ist und eine Dicke entlang der Richtungen der zweiten und der dritten Achse besitzt, wobei der Hochfrequenzabschirmkörper (20, 32, 45) derart angeordnet ist, daß er die elektromagnetische Kopplung zwischen der Gradientenmagnetfelderzeugungs-Spuleneinrichtung (12; 12a, 12b, 12c) und der Hochfrequenzspuleneinrichtung (13), die von einem an die Hochfrequenzspuleneinrichtung (13) angelegten Hochfrequenzimpuls herrührt, unterbricht und eine Zeitkonstante von Wirbelströmen verringert, die in der Oberfläche der Gradientenmagnetfelderzeugungs-Spuleneinrichtung (12; 12a, 12b, 12c) erzeugt werden,

dadurch **gekennzeichnet,** daß der Hochfrequenzabschirmkörper (20, 32, 45) durch Aufdampfen oder Plattieren einer kontinuierlichen Schicht (20B) aus einem leitenden Material auf einer isolierenden Basis (20A) hergestellt ist, wobei das leitende Material eine Dicke von weniger als $1/\sqrt{\pi}$ fo $\mu$ $\sigma$ aufweist, wobei: $\pi$ eine Konstante bezeichnet, die gleich dem Verhältnis zwischen dem Umfang eines Kreises und dem Kreisdurchmesser ist, fo die Larmor-Frequenz von Protonen in dem statischen Magnetfeld bezeichnet, $\sigma$ die Leitfähigkeit des leitenden Materials bezeichnet und $\mu$ die magnetische Permeabilität des leitenden Materials bezeichnet.

2. Mit Magnetresonanz arbeitendes Bildgabegerät nach Anspruch 1, dadurch **gekennzeichnet**, daß der Hochfrequenzabschirmkörper (20) in der Nähe der zur Hochfrequenzspule weisenden Seite der Gradientenmagnetfelderzeugungs-Spuleneinrichtung (12; 12a, 12b, 12c) angeordnet ist.

3. Mit Magnetresonanz arbeitendes Bildgabegerät nach Anspruch 1 oder 2, dadurch **gekennzeichnet,** daß der Hochfrequenzabschirmkörper (20, 32, 45) eine Form besitzt, die ähnlich ist wie diejenige der Gradientenmagnetfelderzeugungs-Spuleneinrichtung (12; 12a, 12b, 12c).

4. Mit Magnetresonanz arbeitendes Bildgabegerät nach Anspruch 1, 2 oder 3, dadurch **gekennzeichnet,** daß die Gradientenmagnetfelderzeugungs-Spuleneinrichtung (12; 12a, 12b, 12c) eine zylindrische Gestalt besitzt, und daß der Hochfrequenzabschirmkörper (20) eine zylindrische Gestalt aufweist.

5. Mit Magnetresonanz arbeitendes Bildgabegerät nach einem der Ansprüche 1 bis 4, dadurch **gekennzeichnet,** daß die isolierende Basis eine organische Faser ist.

6. Mit Magnetresonanz arbeitendes Bildgabegerät nach Anspruch 5, dadurch **gekennzeichnet,** daß die organische Faser aus Polyester hergestellt ist.

7. Mit Magnetresonanz arbeitendes Bildgabegerät nach einem der Ansprüche 1 bis 6, dadurch **gekennzeichnet,** daß die Dicke des Hochfrequenzabschirmkörpers ungefähr 10 μm beträgt.

8. Mit Magnetresonanz arbeitendes Bildgabegerät nach einem der vorhergehenden Ansprüche, dadurch **gekennzeichnet,** daß das leitende Material Kupfer ist.

9. Mit Magnetresonanz arbeitendes Bildgabegerät nach einem der vorhergehenden Ansprüche, dadurch **gekennzeichnet,** daß die Hochfrequenzspuleneinrichtung (13) eine Ganzkörper-Sende- und Empfangsspule ist, die koaxial zu der Gradientenmagnetfelderzeugungs-Spuleneinrichtung (12; 12a, 12b, 12c) angeordnet ist.

10. Mit Magnetresonanz arbeitendes Bildgabegerät nach einem der Ansprüche 1 bis 8, dadurch **gekennzeichnet,** daß die Hochfrequenzspuleneinrichtung (13) eine Sende- und/oder Empfangsspule ist, die im Inneren der Gradientenmagnetfelderzeugungs-Spuleneinrichtung (12; 12a, 12b, 12c) mit einem dazwischen befindlichen Raum angeordnet ist.

11. Mit Magnetresonanz arbeitendes Bildgabegerät nach einem der Ansprüche 1 bis 8, dadurch **gekennzeichnet,** daß die Hochfrequenzspuleneinrichtung (13) eine Ganzkörper-Sende- und Empfangsspule ist, die koaxial zu der Gradientenmagnetfelderzeugungs-Spuleneinrichtung (12; 12a, 12b, 12c) und einer Sende- und/oder Empfangsspule angeordnet ist, die im Inneren der Gradientenmagnetfelderzeugungs-Spuleneinrichtung (12; 12a, 12b, 12c) mit einem dazwischen befindlichen Raum angeordnet ist.

12. Mit Magnetresonanz arbeitendes Bildgabegerät nach einem der Ansprüche 1 bis 11, dadurch **gekennzeichnet,** daß die Statikmagnetfelderzeugungseinrichtung (21) einen Elektromagneten zum Erzeugen eines statischen Magnetfelds in horizontaler Weise aufweist.

13. Mit Magnetresonanz arbeitendes Bildgabegerät nach einem der Ansprüche 1 bis 11, dadurch **gekennzeichnet,** daß die Statikmagnetfelderzeugungseinrichtung (21) einen Elektromagneten zum Erzeugen eines statischen Magnetfelds in vertikaler Weise aufweist.

14. Mit Magnetresonanz arbeitendes Bildgabegerät nach einem der Ansprüche 1 bis 11, dadurch **gekennzeichnet,** daß die Statikmagnetfelderzeugungseinrichtung (21) einen Permanentmagneten zum Erzeugen eines statischen Magnetfelds in horizontaler Weise aufweist.

15. Mit Magnetresonanz arbeitendes Bildgabegerät nach einem der Ansprüche 1 bis 11, dadurch **gekennzeichnet,** daß die Statikmagnetfelderzeugungseinrichtung (21) einen Permanentmagneten zum Erzeugen eines statischen Magnetfelds in vertikaler Weise aufweist.

**Revendications**

1. Appareil d'imagerie par résonance magnétique, comprenant :

   des moyens de production de champ magnétique statique (21), agencés de façon à produire un champ magnétique statique le long de la direction d'un premier axe ;
   des moyens à bobinage de production de champs magnétiques à gradient (12 ; 12a, 12b, 12c) pour produire des champs magnétiques à gradient le long de la direction dudit premier axe et de la direction d'un second et d'un troisième axes orthogonaux audit premier axe ;
   des moyens à bobinage à radio-fréquences (13) pour émettre ou recevoir des ondes électromagnétiques depuis une direction autre que la direction dudit premier axe ; et
   un corps formant écran à radio-fréquences (20, 32, 45) disposé entre lesdits moyens à bobinage de production de champs magnétiques à gradient (12 ; 12a, 12b, 12c) et lesdits moyens à bobinage à radio-fréquences (13) et ayant une épaisseur le long des directions dudit second et dudit troisième axe ; ledit corps formant écran à radio-fréquences (20, 32, 45) étant agencé pour interrompre un accouplement électromagnétique entre lesdits moyens à bobinage de production de champs magnétiques à gradient (12 ; 12a, 12b, 12c) et lesdits moyens à bobinage à radio-fréquences (13) qui résulte d'une impulsion à radio-fréquences appliquée auxdits moyens à bobinage à radio-fréquences (13), et réduire une constante de temps des courants de Foucault engendrés dans la surface desdits moyens à bobinage de production de champs magnétiques à gradient (12 ; 12a, 12b, 12c),

   caractérisé en ce que ledit corps formant écran à radio-fréquences (20, 32, 45) a été formé en évaporant ou en plaquant une couche continue (20B) d'un matériau conducteur sur une base isolante (20A), le matériau conducteur ayant une épaisseur inférieure à $1/\sqrt{\pi f0 \mu \sigma}$, où :

π est une constante égale au rapport de la circonférence d'un cercle et de son diamètre,
f0 est la fréquence de Larmor des protons dans ledit champ magnétique statique,
σ est la conductivité dudit matériau conducteur, et
μ est la perméabilité magnétique dudit matériau conducteur.

2. Appareil d'imagerie à résonance magnétique selon la revendication 1, caractérisé en ce que ledit corps formant écran à radio-fréquences (20) est disposé proche du côté vers le bobinage à radio-fréquences desdits moyens à bobinage de production de champs magnétiques à gradient (12 ; 12a, 12b, 12c).

3. Appareil d'imagerie à résonance magnétique selon l'une ou l'autre des revendications 1 et 2, caractérisé en ce que ledit corps formant écran à radio-fréquences (20, 32, 45) a une forme semblable à celle desdits moyens à bobinage de production de champs magnétiques à gradient (12 ; 12a, 12d, 12c).

4. Appareil d'imagerie par résonance magnétique selon la revendication 1, 2 ou 3, caractérisé en ce que lesdits moyens à bobinage de production de champs magnétiques à gradient (12 ; 12a, 12b, 12c) ont une forme cylindrique, et en ce que ledit corps formant écran à radio-fréquences (20) a une forme cylindrique.

5. Appareil d'imagerie par résonance magnétique selon l'une quelconque des revendications 1 à 4, caractérisé en ce que ladite base isolante est une fibre organique.

6. Appareil d'imagerie par résonance magnétique selon la revendication 5, caractérisé en ce que ladite fibre organique est réalisée en polyester.

7. Appareil d'imagerie par résonance magnétique selon l'une quelconque des revendications 1 à 6, caractérisé en ce que ladite épaisseur dudit corps formant écran à radio-fréquences (20) est d'environ 10 microns.

8. Appareil d'imagerie par résonance magnétique selon l'une quelconque des revendications précédentes, caractérisé en ce que ledit matériau conducteur est du cuivre.

9. Appareil d'imagerie par résonance magnétique selon l'une quelconque des revendications précédentes, caractérisé en ce que lesdits moyens à bobinage à radio-fréquences (13) sont un bobinage à corps plein d'émission et de réception qui est disposé coaxialement avec lesdits moyens à bobinage de production de champs magnétiques à gradient (12 ; 12a, 12b, 12c).

10. Appareil d'imagerie par résonance magnétique selon l'une quelconque des revendications 1 à 8, caractérisé en ce que lesdits moyens à bobinage à radio-fréquences (13) comprennent un bobinage d'émission et/ou de réception qui est disposé à l'intérieur desdits moyens à bobinage de production de champs magnétiques à gradient (12 ; 12a, 12b, 12c) avec un espace entre eux.

11. Appareil d'imagerie par résonance magnétique selon l'une quelconque des revendications 1 à 8, caractérisé en ce que lesdits moyens à bobinage à radio-fréquence (13) sont un bobinage à corps plein d'émission et de réception qui est disposé coaxialement avec lesdits moyens à bobinage de production de champs magnétiques à gradient (12 ; 12a, 12b, 12c) et un bobinage d'émission et/ou de réception qui est disposé à l'intérieur desdits moyens à bobinage de production de champs magnétiques à gradient (12 ; 12a, 12b, 12c) avec un espace entre eux.

12. Appareil d'imagerie par résonance magnétique selon l'une quelconque des revendications 1 à 11, caractérisé en ce que lesdits moyens de production de champ magnétique statique (21) comprennent un électroaimant pour produire un champ magnétique statique horizontalement.

13. Appareil d'imagerie par résonance magnétique selon l'une quelconque des revendications 1 à 11, caractérisé en ce que lesdits moyens de production de champ magnétique statique (21) comprennent un électroaimant pour produire un champ magnétique statique verticalement.

14. Appareil d'imagerie par résonance magnétique selon l'une quelconque des revendications 1 à 11, caractérisé en ce que lesdits moyens de production de champ magnétique statique (21) comprennent un aimant permanent pour produire un champ magnétique statique horizontalement.

15. Appareil d'imagerie par résonance magnétique selon l'une quelconque des revendications 1 à 11, caractérisé en ce que lesdits moyens de production de champ magnétique statique (21) comprennent un aimant permanent pour produire un champ magnétique statique verticalement.

F I G. 1

FIG. 2

FIG. 3

FIG. 4

FIG. 5